# EUROPEAN PATENT APPLICATION

(11) **EP 4 818 717 A1**
(43) Date of publication of application: **07.10.2026**
(21) Application number: 24896676.4
(22) Date of filing: 28.11.2024
(51) Int. Cl.: G01R 31/378

(54) **BATTERY MANAGEMENT SYSTEM, BATTERY PACK, AND ELECTRICAL APPARATUS**

(30) Priority: 30.11.2023 CN 202311644337
(71) Applicant: Contemporary Amperex Technology Co., Limited, Ningde, Fujian 352100 (CN)
(72) Inventor: CHEN, Hui, Ningde, Fujian 352100 (CN); GUO, Maobo, Ningde, Fujian 352100 (CN); YE, Fuming, Ningde, Fujian 352100 (CN); YAN, Zhiwei, Ningde, Fujian 352100 (CN)
(74) Representative: Ran, Handong
(86) International application number: PCT/CN2024/135406
(87) International publication number: WO 2025/113591

(57) **Abstract**

Provided in the present disclosure are a battery management system, a battery pack, and an electrical apparatus. The battery management system comprises: a plurality of switch assemblies, each switch assembly being connected between a battery and a corresponding load, and said assemblies being used for establishing or severing a connection between the battery and the corresponding load; a sampling circuit, the sampling circuit comprising sampling branch circuits in one-to-one correspondence with the plurality of switch assemblies, and each sampling branch circuit being used for collecting the voltage at a sampling measurement point, wherein a first end of each sampling branch circuit is connected to a corresponding switch assembly, and the connection point is a sampling measurement point; a second end of each sampling branch circuit is connected to a voltage source, and the connection point is a reference sampling point; and a third end of each sampling branch circuit is connected to a sampling module; the voltage source, which is used for providing reference voltages to the reference sampling points; and the sampling module, which is connected to a high voltage ground and is used for obtaining the voltage of each sampling measurement point relative to the corresponding reference sampling point.

## Description

### CROSS-REFERENCE TO RELATED APPLICATIONS

The present disclosure claims priority to Chinese patent application No. 202311644337.1, filed with the China National Intellectual Property Administration on November 30, 2023, and entitled "SAMPLING CIRCUIT, BATTERY MANAGEMENT SYSTEM, BATTERY PACK, AND POWER CONSUMING APPARATUS", which is incorporated herein by reference in its entirety.

### TECHNICAL FIELD

The present disclosure relates to the field of power management technologies, and in particular, to a battery management system, a battery pack, and a power consuming apparatus.

### BACKGROUND

With the development of new energy technologies, batteries are being increasingly widely used in various power consuming apparatuses such as mobile phones, laptop computers, electric scooters, electric vehicles, electric aircraft, and electric ships.

During the operation of a power consuming apparatus, a power supply can supply power to various power consuming units to maintain the normal operation of the power consuming units. A plurality of relay switches are typically disposed in high-voltage lines corresponding to the positive and negative electrodes of the battery. To ensure the reliability of the battery during use, voltage sampling needs to be performed at various detection points within the battery, enabling corresponding execution and processing based on sampling results.

However, circuit designs for voltage sampling in related technologies are complex and costly.

### SUMMARY

Embodiments of the present disclosure provide a battery management system, a battery pack, and a power consuming apparatus, to optimize the circuit design of a sampling circuit, thereby improving the operational reliability of a battery.

According to a first aspect, embodiments of the present disclosure provide a battery management system, including:
a plurality of switch assemblies, each switch assembly being connected between a battery and a corresponding load, and configured to connect the battery to the corresponding load or disconnect the battery from the corresponding load;
a sampling circuit, the sampling circuit including sampling branches in a one-to-one correspondence with the plurality of switch assemblies, and each sampling branch being configured to acquire a voltage at a sampling detection point, where a first end of each sampling branch is connected to a corresponding switch assembly, and a connection point is the sampling detection point; a second end of each sampling branch is connected to a voltage source, and a connection point is a reference sampling point; and a third end of each sampling branch is connected to a sampling module;
the voltage source, configured to supply a reference voltage to the reference sampling point; and
the sampling module, connected to a high-voltage ground, and configured to obtain a voltage of each sampling detection point with respect to the reference sampling point.

Through the arrangement of the voltage source, the sampling module, and the sampling branches, the reference voltage may be supplied to the reference sampling point through the voltage source, so that a voltage of the reference sampling point with respect to a reference ground is the reference voltage. The sampling module may determine a sampling result based on a sampled voltage of the sampling detection point with respect to the reference sampling point and the reference voltage between the reference sampling point and the reference ground. In this way, the sampling branches share the same reference sampling point, and sampling is directly performed with respect to the reference voltage, thereby simplifying the circuit design and reducing circuit costs. In addition, the sampling module is connected to the high-voltage ground, so that the issue of insulation withstand voltage no longer needs to be considered for the sampling module, and the voltage withstand rating selection for a switch device is relatively flexible. In addition, the sampling circuit belongs to a high-voltage region, and is no longer connected to a low voltage. In addition, interference immunity can be improved, and an isolation device does not need to be disposed, thereby reducing costs.

In a possible implementation of the first aspect, the battery management system further includes: a voltage conversion module, the voltage conversion module being connected to the voltage source, and configured to convert the reference voltage of the voltage source to provide corresponding sampling ranges for sampling detection points with different reference voltage requirements, respectively. In this way, the reference voltage supplied by the voltage source is adjustable, so that the sampling detection points can be sampled with respect to different reference voltages, thereby meeting different sampling requirements.

In a possible implementation of the first aspect, the plurality of switch assemblies include at least one first switch assembly and/or at least one second switch assembly, and the sampling branches include: a first sampling branch disposed corresponding to the first switch assembly, a sampling detection point corresponding to the first sampling branch being connected to a first terminal of the battery, or a sampling detection point corresponding to the first sampling branch being connected to the first terminal of the battery by the first switch assembly; and a second sampling branch disposed corresponding to the second switch assembly, a sampling detection point corresponding to the second sampling branch being connected to a second terminal of the battery by the second switch assembly. The first sampling branch and the second sampling branch may perform voltage sampling on the sampling detection point connected to the first terminal of the battery and the sampling detection point connected to the second terminal of the battery, respectively, so that the first sampling branch and/or the second sampling branch share the same reference sampling point, and sampling is directly performed with respect to the reference voltage, thereby simplifying the circuit design and reducing circuit costs.

In a possible implementation of the first aspect, the plurality of switch assemblies further include switch assemblies connected in parallel, and the sampling branches further include: a third sampling branch, connected to one end of the switch assemblies connected in parallel; and a fourth sampling branch, connected to the other end of the switch assemblies connected in parallel. In this way, when at least two switch assemblies are connected in parallel, the at least two switch assemblies can multiplex the same sampling branch (including the third sampling branch and the fourth sampling branch), so that through multiplexing of the sampling branch, the circuit design can be simplified, and circuit costs can be reduced.

In a possible implementation of the first aspect, the sampling branch includes: a first sampling unit and a second sampling unit, the first sampling unit and the second sampling unit being connected in series. The first sampling unit and the second sampling unit are disposed to divide the voltage at the sampling detection point, so that the divided voltage falls within the sampling range.

In a possible implementation of the first aspect, sampling points in the sampling branch include a first sampling point, and the sampling module includes a first sampling end; the first sampling point is disposed between the first sampling unit and the second sampling unit; and the first sampling point is connected to the first sampling end of the sampling module. Through the arrangement that the first sampling end of the sampling module is connected to the first sampling point of the sampling branch, voltage sampling of the sampling branch with respect to the reference voltage is implemented.

In a possible implementation of the first aspect, sampling points in the sampling branch include a second sampling point, and the sampling module includes a second sampling end; the second sampling point of the sampling branch is disposed at two ends of the second sampling unit; and the second sampling point is connected to the second sampling end of the sampling module. Through the arrangement that the second sampling end of the sampling module is connected to the second sampling point of the sampling branch, so that the terminal voltage of the second sampling unit can be directly sampled, and the voltage of the sampling detection point with respect to the reference sampling point can be determined with reference to a voltage division ratio of the first sampling unit to the second sampling unit.

In a possible implementation of the first aspect, the second sampling end of the sampling module is a differential sampling end. The terminal voltage of the second sampling unit can be directly obtained through differential sampling.

In a possible implementation of the first aspect, the sampling branch further includes: a switch unit, the switch unit being configured to connect the sampling branch. Through the arrangement of the switch unit, the application of the sampling branch can be flexibly controlled.

In a possible implementation of the first aspect, the sampling module is connected to the switch unit, and the sampling module is configured to control the switch unit to be turned on or turned off. The switch unit is controlled through the sampling module to be turned on, so that the switch unit can be controlled to be turned on when sampling needs to be performed, and the switch unit can be turned off when sampling is not required, thereby improving the flexibility of sampling control.

In a possible implementation of the first aspect, the switch unit includes at least one of a transistor, an optoelectronic device, and a relay. Through the arrangement of the switch device, the on-off control of the sampling branch can be implemented.

In a possible implementation of the first aspect, the voltage source is connected to the second terminal of the battery, and the reference voltage is a voltage difference between the reference sampling point and the second terminal of the battery. The second terminal of the battery is used as the reference ground, and the sampling module may determine a sampling result based on a sampled voltage of the sampling point in the sampling branch with respect to the reference sampling point and the reference voltage between the reference sampling point and the reference ground.

In a possible implementation of the first aspect, the switch assembly includes any one of a main positive switch, a main negative switch, a pre-charging switch, a main positive direct current charging switch, a main positive alternating current charging switch, a main negative charging switch, a heating switch, and a load switch. Through voltage sampling at the sampling detection points at two ends of each switch assembly, whether a fault such as sticking occurs at the switch assembly may be determined based on a voltage difference between the two ends of the switch assembly.

In a possible implementation of the first aspect, the battery management system further includes: a low-voltage power supply; a power supply isolation module, connected between the low-voltage power supply and the voltage source; a low-voltage control module; and a communication isolation module, connected between a voltage input end of the low-voltage control module and a sampling output end of the sampling module. Through the arrangement of the sampling circuit, isolation modules in the battery management system can be reduced, thereby reducing the number of devices and circuit costs.

According to a second aspect, the embodiments of the present disclosure provide a battery pack, including a battery and the battery management system provided in any embodiment of the first aspect.

According to a third aspect, the embodiments of the present disclosure provide a power consuming apparatus, including the battery pack provided in any embodiment of the second aspect.

Compared with the related technologies, for the battery management system, the battery pack, and the power consuming apparatus provided in the embodiments of the present disclosure, through the arrangement of the voltage source, the sampling module, and the sampling branches, the reference voltage may be supplied to the reference sampling point through the voltage source, so that a voltage of the reference sampling point with respect to a reference ground is the reference voltage. The sampling module may determine a sampling result based on a sampled voltage of the sampling detection point with respect to the reference sampling point and the reference voltage between the reference sampling point and the reference ground. In this way, the sampling branches share the same reference sampling point, and sampling is directly performed with respect to the reference voltage, thereby simplifying the circuit design and reducing circuit costs. In addition, the sampling module is connected to the high-voltage ground, so that the issue of insulation withstand voltage no longer needs to be considered for the sampling module, and the voltage withstand rating selection for a switch device is relatively flexible. In addition, the sampling circuit belongs to a high-voltage region, and is no longer connected to a low voltage. In addition, interference immunity can be improved, and an isolation device does not need to be disposed, thereby reducing costs.

### BRIEF DESCRIPTION OF THE DRAWINGS

To describe the technical solutions of the embodiments of the present disclosure more clearly, the following briefly describes the accompanying drawings required for the embodiments of the present disclosure. Apparently, the accompanying drawings in the following description show only some embodiments of the present disclosure, and persons of ordinary skill in the art may still derive other drawings from these accompanying drawings without creative efforts.
FIG. 1 is a schematic diagram of a modular structure of a sampling circuit according to an embodiment of the present disclosure;
FIG. 2 is a schematic diagram of a modular structure of a sampling circuit according to another embodiment of the present disclosure;
FIG. 3 is a schematic diagram of a modular structure of a sampling circuit according to yet another embodiment of the present disclosure;
FIG. 4 is a schematic diagram of a modular structure of a sampling circuit according to still another embodiment of the present disclosure;
FIG. 5 is a schematic diagram of a modular structure of a sampling circuit according to still another embodiment of the present disclosure;
FIG. 6 is a schematic diagram of a circuit structure of a sampling circuit according to an embodiment of the present disclosure;
FIG. 7 is a schematic diagram of a circuit structure of a sampling circuit according to another embodiment of the present disclosure;
FIG. 8 is a schematic diagram of a circuit structure of a conventional sampling manner according to an embodiment of the present disclosure;
FIG. 9 is a schematic diagram of a circuit structure of a differential sampling manner according to an embodiment of the present disclosure;
FIG. 10 is a schematic diagram of a circuit structure of a sampling circuit according to still another embodiment of the present disclosure;
FIG. 11 is a schematic diagram of a circuit structure of a sampling branch according to an embodiment of the present disclosure;
FIG. 12 is a schematic diagram of a circuit structure of a sampling branch according to another embodiment of the present disclosure; and
FIG. 13 is a schematic diagram of a modular structure of a battery management system according to an embodiment of the present disclosure.

In the accompanying drawings:
10. sampling module; 20. sampling branch; 21. first sampling branch; 22. second sampling branch; 23. first sampling unit; 24. second sampling unit; 25. switch unit; 251. control assembly; 252. controlled assembly; 12. first sampling unit; 30. switch assembly; 40. battery; 50. voltage source; 60. voltage conversion module; Q1. first MOSFET; Qen. enable switch; Ls. light-emitting source; Po. light receiver; Q2. second MOSFET; Q3. third MOSFET; K1. main negative switch; K2. main positive switch; K3. pre-charging switch; K4. main positive direct current charging switch; K5. main negative charging switch; K6. main positive alternating current charging switch; K7. heating switch; K8. load switch; 13. low-voltage power supply; 14. power supply isolation module; 15. communication isolation module; and 16. low-voltage control module.

### DETAILED DESCRIPTION

The features and exemplary embodiments of various aspects of the present disclosure are described below in detail. To make the objectives, technical solutions, and advantages of the present disclosure clearer and more comprehensible, the following further describes the present disclosure in detail with reference to the accompanying drawings and specific embodiments. It should be understood that the specific embodiments described herein are provided only for describing the present disclosure rather than limiting the present disclosure. Persons skilled in the art may implement the present disclosure without some of these specific details. The following descriptions of the embodiments are merely intended to provide a better understanding of the present disclosure by showing examples of the present disclosure.

It should be noted that the relational terms herein such as first and second are used only to differentiate an entity or operation from another entity or operation, and do not require or imply any actual relationship or sequence between these entities or operations. Moreover, the terms "include", "comprise", or any variation thereof are intended to cover a non-exclusive inclusion. Therefore, in the context of a process, method, object, or device that includes a series of elements, the process, method, object, or device not only includes such elements, but also includes other elements not specified expressly, or may include inherent elements of the process, method, object, or device. If no more limitations are made, an element limited by "include ..." does not exclude other same elements existing in the process, the method, the article, or the device which includes the element.

It should be noted that the embodiments in the present disclosure and the features in the embodiments may be combined with each other without causing any conflict. The embodiments are described below in detail with reference to the accompanying drawings.

With the development of new energy technologies, batteries are being increasingly widely used in various power consuming apparatuses such as mobile phones, laptop computers, electric scooters, electric vehicles, electric aircraft, and electric ships.

During the operation of a power consuming apparatus, a power supply can supply power to various power consuming units to maintain the normal operation of the power consuming units. A plurality of relay switches are typically disposed in high-voltage lines corresponding to the positive and negative electrodes of the battery. To ensure the reliability of the battery during use, voltage sampling needs to be performed at various detection points within the battery, enabling corresponding execution and processing based on sampling results.

However, the circuit architecture for voltage sampling in related technologies has some defects.

To resolve the foregoing technical problems, embodiments of the present disclosure provide a sampling circuit, a battery management system, a battery pack, and a power consuming apparatus. The following first describes the sampling circuit provided in the embodiments of the present disclosure.

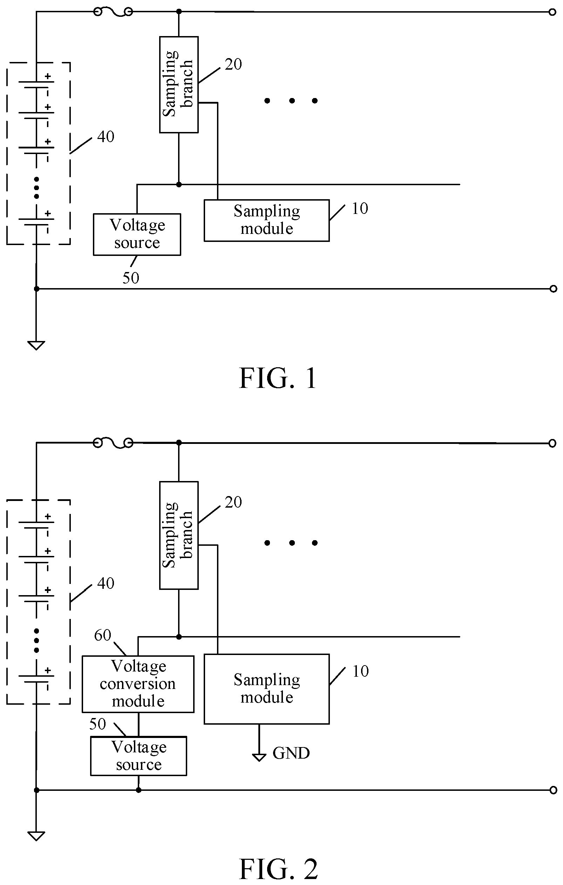

According to some embodiments of the present disclosure, referring to FIG. 1, the present disclosure provides a sampling circuit. The sampling circuit includes a voltage source 50, a sampling module 10, and sampling branches 20.

The voltage source 50 is connected to a reference sampling point. The voltage source 50 may supply a reference voltage to the reference sampling point, so that a voltage of the reference sampling point with respect to a reference ground is the reference voltage.

An example in which the voltage source 50 maintains the reference voltage at 5 V is used. If the voltage at the reference ground is 0 V, the voltage source 50 can enable the voltage at the reference sampling point to be 5 V. If the voltage of the reference ground with respect to the ground is 10 V, the voltage source 50 can enable the voltage at the reference sampling point to be 15 V.

The sampling branches 20 may be connected between corresponding sampling detection points in a battery 40 and the reference sampling point.

A sampling end of the sampling module 10 may be connected to the sampling branch 20. The sampling module 10 may obtain, through the sampling end, a sampled signal acquired by a corresponding sampling branch 20, and may determine, based on the sampled signal, a voltage at the sampling detection point corresponding to the sampling branch 20 with respect to the reference sampling point. The voltage of the reference sampling point with respect to the reference ground is a fixed reference voltage. Therefore, after determining the voltage of each sampling detection point with respect to the reference sampling point, the sampling module 10 may calculate a sum of the voltage and the reference voltage, to obtain a voltage of the sampling detection point with respect to the reference ground.

It should be noted that when a plurality of sampling detection points are provided, a plurality of sampling branches 20 that respectively correspond to the plurality of sampling detection points may be disposed, and each sampling branch 20 is connected between a corresponding sampling detection point and the reference sampling point. A plurality of sampling ends of the sampling module 10 are respectively connected to the plurality of sampling branches 20. The sampling module 10 may obtain the voltage of each corresponding sampling detection point with respect to the reference sampling point by using each sampling end, and then perform voltage sampling of the plurality of sampling detection points with respect to the reference ground in combination with the reference voltage of the reference sampling point with respect to the reference ground.

It should be noted that the foregoing implementation obtains voltage samples of the plurality of sampling detection points with respect to a fixed reference ground. In an actual sampling process, besides the reference ground, sampling requirements for a plurality of reference points may exist. When the sampling circuit needs to implement voltage sampling of the plurality of reference points, because the voltage of each sampling detection point with respect to the reference ground is known, some sampling detection points may be determined from the plurality of sampling detection points as the reference points. Each of the voltages of the remaining sampling detection points with respect to each reference point is a difference between the voltage of the sampling detection point with respect to the reference ground and the voltage of each reference point with respect to the reference ground. That is, after the voltage of any sampling detection point with respect to the reference ground is determined, the sampling detection point may be used as a reference point, to obtain the voltages of the remaining sampling detection points with respect to the reference point.

In this embodiment, through the arrangement of the voltage source 50, the sampling module 10, and the sampling branches 20, the reference voltage may be supplied to the reference sampling point through the voltage source 50, so that a voltage of the reference sampling point with respect to a reference ground is the reference voltage. The sampling branch 20 may sample the voltage at the sampling detection point. The sampling module 10 is connected to the sampling branch 20, and may obtain a sampled voltage of a corresponding sampling detection point with respect to the reference sampling point. The sampling module 10 may determine the voltage of the sampling detection point with respect to the reference ground based on the sampled voltage of the sampling detection point with respect to the reference sampling point and the reference voltage between the reference sampling point and the reference ground. When a plurality of sampling detection points are provided, some of the sampling detection points may alternatively be used as the reference point, to obtain the voltages of the remaining sampling detection points with respect to the reference point, thereby implementing the voltage sampling of the plurality of reference points through a high-voltage sampling architecture.

It should be noted that in the related technologies, when the voltage sampling of the plurality of reference points is implemented, a sampling circuit architecture usually needs to be disposed for each reference point. The sampling circuit architecture includes an isolation power supply module, a sampling chip, an isolation communication module, and a corresponding low-voltage controller. That is, when the voltage sampling of the plurality of reference points is implemented, many devices need to be disposed in a circuit architecture. Consequently, apparatus costs and device space are high, and overall apparatus space and production costs are further affected. Compared with the related technologies, in the foregoing embodiments, a single reference ground is disposed, so that the voltage of each sampling detection point with respect to the reference ground may be obtained. When the voltage sampling of the plurality of reference points is implemented, any sampling detection point is used as a reference point, and a voltage of each sampling detection point with respect to the reference point may be obtained through calculation. In addition, because only one reference ground is provided, a plurality of sampling circuit architectures do not need to be disposed, so that the number of devices and costs of the apparatus can be effectively reduced.

According to some embodiments of the present disclosure, referring to FIG. 2, a second terminal of the battery 40 may be selected as the reference ground, the voltage source 50 may be connected to the second terminal of the battery 40, and the reference voltage supplied by the voltage source 50 is a voltage difference between the reference sampling point and the second terminal of the battery 40.

In this embodiment, the second terminal of the battery 40 is used as reference ground, so that the voltage of the reference sampling point with respect to the second terminal of the battery 40 is the reference voltage. After obtaining the voltage of the sampling detection point with respect to the reference sampling point, the sampling module calculates a sum of the voltage and the reference voltage to obtain the voltage of the sampling detection point with respect to the second terminal of the battery 40.

In this embodiment of the present disclosure, when the second terminal of the battery 40 may be selected as the reference ground, the reference ground may also be referred to as a "high-voltage ground". FIG. 2 is used as an example. The sampling module 10 may be connected to the high-voltage ground GND. The high-voltage ground GND may be a reference ground supplied by a high-voltage system. For example, the high-voltage system may be a battery system. It should be noted that in the field, an operating voltage of the battery system falls under Class B. For example, a maximum operating voltage is between 60 V and 1500 V, and therefore is defined as the high-voltage system. In this case, a reference ground supplied by the second terminal (that is, a negative electrode of the battery 40) of the battery 40 may be generally referred to as the high-voltage ground GND.

It should be further noted that the sampling module 10 is connected to the high-voltage ground GND. In this case, the issue of insulation withstand voltage no longer needs to be considered, and the voltage withstand rating selection for a switch device is relatively flexible. In addition, sampling circuits are in a high-voltage region, and are not connected to a low voltage, so that no impact of common-mode interference exists, and interference immunity is better. In addition, no isolation device needs to be disposed, so that costs can be reduced. It should be noted that FIG. 2 is used as an example herein to describe that the sampling module 10 is connected to the high-voltage ground GND, but this is not limited thereto. In other drawings, the sampling module 10 is also connected to the high-voltage ground GND.

According to some embodiments of the present disclosure, still referring to FIG. 2, the sampling circuit further includes a voltage conversion module 60. The voltage conversion module 60 is connected to the voltage source 50, and is configured to convert the reference voltage of the voltage source to provide corresponding sampling ranges for sampling detection points with different reference voltage requirements, respectively.

The voltage conversion module 60 may be connected between the voltage source 50 and the reference sampling point. The voltage conversion module 60 may receive the reference voltage supplied by the voltage source 50, and perform voltage conversion on the reference voltage, to provide corresponding sampling ranges for sampling detection points with different reference voltage requirements, respectively. In this way, the reference voltage supplied by the voltage source 50 is adjustable, so that the sampling detection points can be sampled with respect to different reference voltages, thereby meeting different sampling requirements.

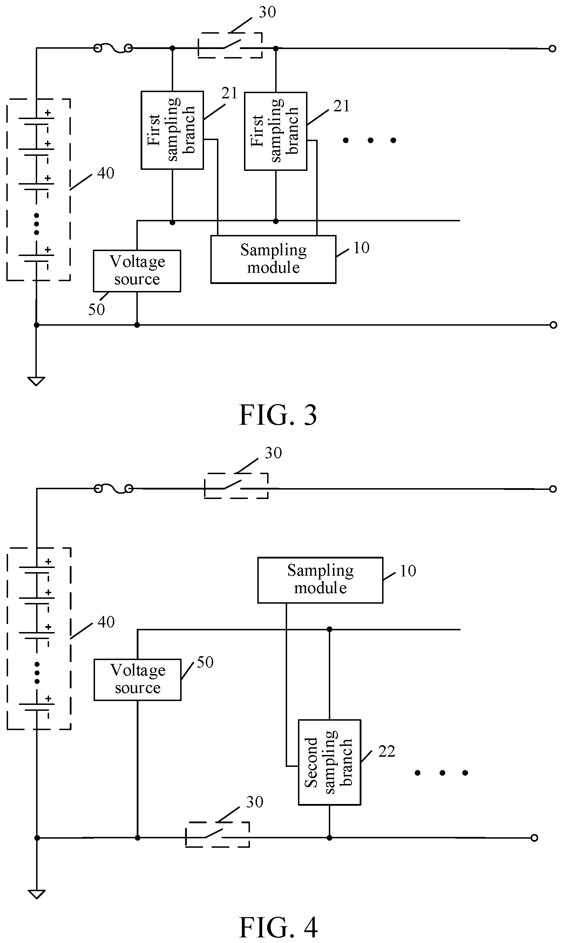

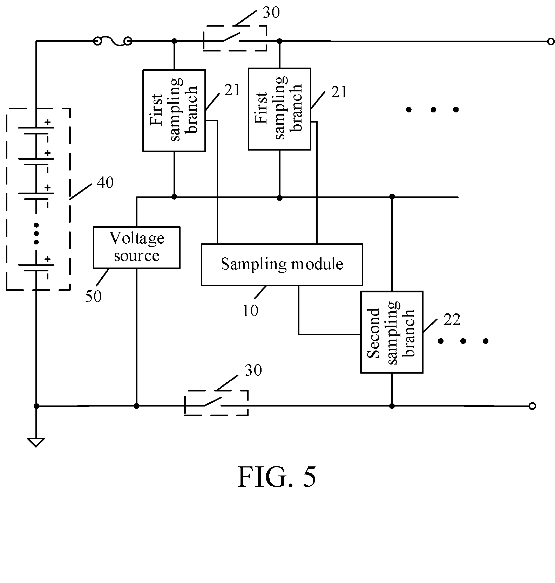

According to some embodiments of the present disclosure, referring to FIG. 3 to FIG. 5, as shown in FIG. 3, the sampling branches 20 may include a first sampling branch 21. As shown in FIG. 4, the sampling branches 20 may also include a second sampling branch 22. As shown in FIG. 5, the sampling branches 20 may further include both the first sampling branch 21 and the second sampling branch 22.

As shown in FIG. 3, a sampling detection point corresponding to the first sampling branch 21 may be directly connected to a first terminal of the battery 40, or may be connected to a first terminal of the battery 40 by a switch assembly 30. As shown in FIG. 4, a sampling detection point corresponding to the second sampling branch 22 may be connected to the second terminal of the battery 40 by a switch assembly 30. The first terminal of the battery 40 may be a positive electrode, and the second terminal may be a negative electrode.

In the first sampling branch 21, when the sampling detection point is directly connected to the first terminal of the battery 40, the first sampling branch 21 may directly sample the voltage at the first terminal of the battery 40. When the reference ground is disposed as the second terminal of the battery 40, the voltage at the first terminal of the battery 40 with respect to the second terminal of the battery 40, that is, the terminal voltage of the battery 40, may be determined based on a sum of the voltage of the sampling detection point with respect to the reference sampling point and the reference voltage.

In the first sampling branch 21, when the sampling detection point is connected to the first terminal of the battery 40 by the switch assembly 30, when the switch assembly 30 is turned on, voltages at two ends of the switch assembly 30 are consistent. In this case, the voltage at the sampling detection point is equal to the voltage at the first terminal of the battery 40.

When the switch assembly 30 is turned off, a voltage difference exists between the two ends of the switch assembly 30. Because one end of the switch assembly 30 is connected to the first terminal of the battery 40, in this case, the sampling branch 20 may be connected to a sampling detection point located at the other end of the switch assembly 30, and the sampling module 10 performs voltage sampling at the sampling detection point to determine the voltage of the sampling detection point with respect to the reference sampling point, and obtain the voltage of the sampling detection point with respect to the second terminal of the battery based on the sum of the voltage of the sampling detection point with respect to the reference sampling point and the reference voltage.

In the second sampling branch 22, when the sampling detection point is connected to the second terminal of the battery 40 by the switch assembly 30, when the switch assembly 30 is turned on, voltages at two ends of the switch assembly 30 are the same. In this case, the voltage at the sampling detection point is equal to the voltage at the second terminal of the battery 40. When the switch assembly 30 is turned off, a voltage difference exists between the two ends of the switch assembly 30. Because one end of the switch assembly 30 is connected to the second terminal of the battery 40, in this case, the sampling branch 20 may be connected to a sampling detection point located at the other end of the switch assembly 30, and the sampling module 10 performs voltage sampling at the sampling detection point to determine the voltage of the sampling detection point with respect to the reference sampling point, and obtain the voltage of the sampling detection point with respect to the second terminal of the battery based on the sum of the voltage of the sampling detection point with respect to the reference sampling point and the reference voltage.

In the foregoing embodiment, an example in which the first terminal of the battery 40 is the positive electrode and the second terminal of the battery 40 is the negative electrode, when only the first sampling branch 21 is disposed in the sampling branch 20, the sampling detection point corresponding to the first sampling branch 21 is a positive sampling detection point, and a voltage of the positive sampling detection point with respect to the second terminal of the battery can be sampled by using the first sampling branch 21 and the sampling module 10. When only the second sampling branch 22 is disposed in the sampling branch 20, the sampling detection point corresponding to the second sampling branch 22 is a negative sampling detection point, and a voltage of the negative sampling detection point with respect to the second terminal of the battery can be sampled by using the second sampling branch 22 and the sampling module 10.

If the sampling branch 20 includes the first sampling branch 21 and the second sampling branch 22, the first sampling branch 21 may sample the voltage of the positive sampling detection point with respect to the second terminal of the battery, and the second sampling branch 22 may sample the voltage of the negative sampling detection point with respect to the second terminal of the battery, so that voltage sampling can be performed for each node that requires voltage sampling in a positive loop and a negative loop.

When the sampling branch 20 includes the first sampling branch 21 and the second sampling branch 22, at least one first sampling branch 21 is provided, and at least one second sampling branch 22 is also provided.

Because the first sampling branch 21 and the second sampling branch 22 have the same reference sampling point, after a voltage of the positive sampling detection point with respect to the reference sampling point and a voltage of the negative sampling detection point with respect to the reference sampling point are determined, a sum of the voltage of the positive sampling detection point with respect to the reference sampling point and the voltage of the negative sampling detection point with respect to the reference sampling point may be further calculated, to obtain a voltage of the positive sampling detection point with respect to the negative sampling detection point.

When both a plurality of first sampling branches 21 and a plurality of second sampling branches 22 are provided, voltage sampling between any two positive sampling detection points, voltage sampling between any two negative sampling detection points, and voltage sampling between any positive sampling detection point and any negative sampling detection point may be implemented.

An example in which voltage sampling is performed between two positive sampling detection points is used. Based on two first sampling branches 21 that correspond to the two positive sampling detection points, respectively, the sampling module 10 may respectively obtain voltages of the two positive sampling detection points with respect to the reference sampling point. A voltage difference between the two positive sampling detection points is a difference between a voltage of one positive sampling detection point with respect to the reference sampling point and a voltage of the other positive sampling detection point with respect to the reference sampling point.

When one of the two positive sampling detection points is directly connected to the first terminal of the battery, and the other one is connected to the first terminal of the battery by the switch assembly 30: if the switch assembly 30 is turned on, the potentials of the two positive sampling detection points should be the same, that is, the voltage difference is 0; and if the switch assembly 30 is normally open, a particular voltage difference should exist between the two positive sampling detection points.

After the voltage difference between the two positive sampling detection points is calculated, the voltage difference may be compared with a preset voltage threshold. If the voltage difference is greater than the voltage threshold, it indicates that the switch assembly 30 is normally open. If the voltage difference is less than the voltage threshold, it indicates that the switch assembly 30 is not normally open, and a fault such as relay sticking may exist.

The voltage threshold may be a fixed voltage, or may be associated with the terminal voltage of the battery 40. For example, when the terminal voltage of the battery 40 is 800 V, the voltage threshold may be 1%, 2%, or another proportion of the terminal voltage of the battery 40.

Similarly, when voltage sampling is performed between two negative sampling detection points, based on two second sampling branches 22 that correspond to the two negative sampling detection points, respectively, the sampling module 10 may respectively obtain voltages of the two negative sampling detection points with respect to the reference sampling point. A voltage difference between the two negative sampling detection points is a difference between a voltage of one negative sampling detection point with respect to the reference sampling point and a voltage of the other negative sampling detection point with respect to the reference sampling point.

When the voltage difference between the two positive sampling detection points needs to be determined, a difference between the voltage of one positive sampling detection point with respect to the reference sampling point and the voltage of the other positive sampling detection point with respect to the reference sampling point may be calculated, to obtain the voltage difference between the two positive sampling detection points. When the voltage difference between the two negative sampling detection points needs to be determined, a difference between the voltage of one negative sampling detection point with respect to the reference sampling point and the voltage of the other negative sampling detection point with respect to the reference sampling point may be calculated, to obtain the voltage difference between the two negative sampling detection points. When the voltage difference between one positive sampling detection point and one negative sampling detection point needs to be determined, the sum of the voltage of the positive sampling detection point with respect to the reference sampling point and the voltage of the negative sampling detection point with respect to the reference sampling point may be calculated, to obtain the voltage difference between the positive sampling detection point and the negative sampling detection point.

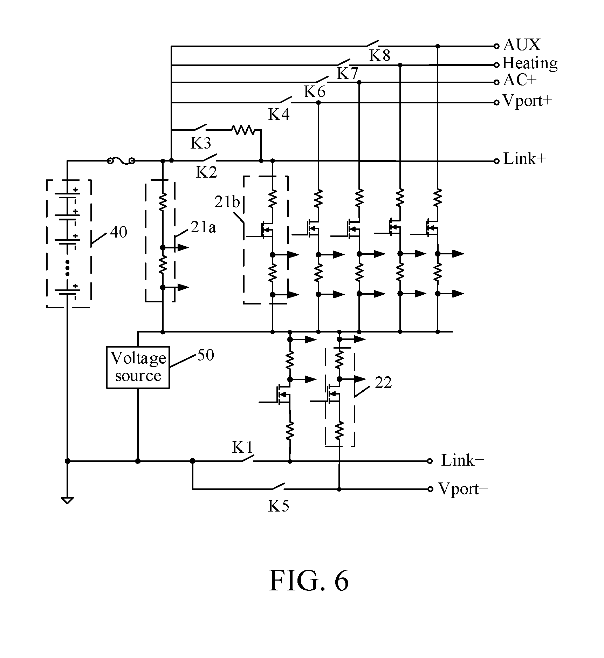

According to some embodiments of the present disclosure, referring to FIG. 6, the switch assembly 30 may include any one of a main positive switch K2, a main negative switch K1, a pre-charging switch K3, a main positive direct current charging switch K4, a main positive alternating current charging switch K6, a main negative charging switch K5, a heating switch K7, and a load switch K8.

The positive electrode and the negative electrode of the battery 40 may be connected to a corresponding charging device, functional circuit, or load by using different switch assemblies 30. A sampling detection point is disposed on a side of each switch assembly 30 away from the first terminal or the negative electrode of the battery 40, and the voltage at the sampling detection point is sampled by using the sampling branch 20, so that state diagnosis can be performed on each switch assembly 30 with reference to the positive voltage and the negative voltage of the battery 40, thereby improving the reliability of the battery during operation.

In an optional implementation, in the foregoing embodiment, the positive sampling detection points may include a sampling detection point connected to the positive electrode of the battery 40 and sampling detection points that pass through the main positive switch K2, the main positive direct current charging switch K4, the main positive alternating current charging switch K6, the heating switch K7, and the load switch K8, respectively. That is, a total of six positive sampling detection points may be provided. Similarly, the negative sampling detection points may include the second terminal of the battery connected to the negative electrode of the battery 40 and sampling detection points that pass through the main negative switch K1 and the main negative charging switch K5, respectively. That is, three negative sampling detection points may be provided. When voltage sampling of a plurality of reference points is implemented, at least one of the three negative sampling detection points may be used as a reference point, to calculate a voltage of any positive sampling detection point with respect to the reference point. That is, for six positive sampling detection points and three negative sampling detection points, a voltage of each positive sampling detection point with respect to each negative sampling detection point may be obtained, and a total of 18 sampled voltages are provided.

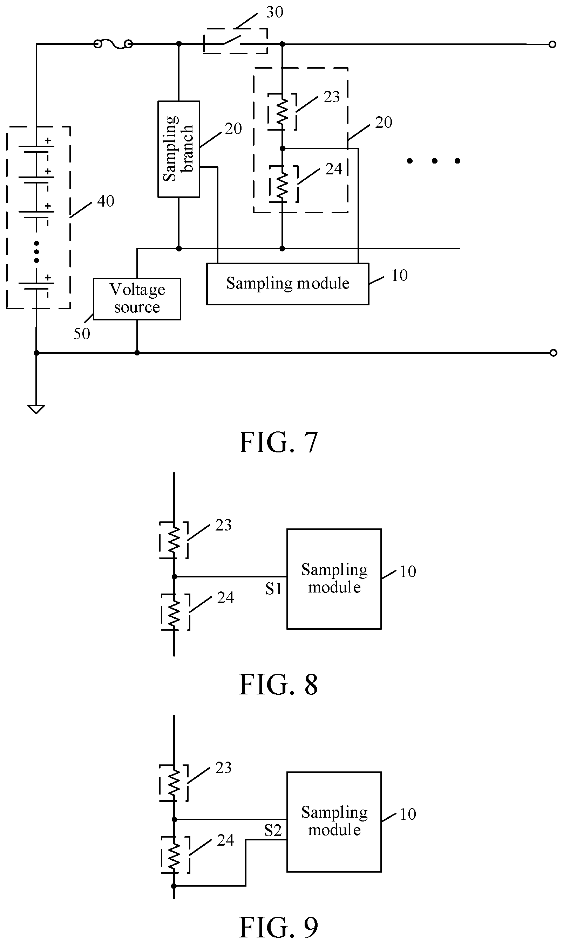

According to some embodiments of the present disclosure, referring to FIG. 7, the sampling branch 20 may include a first sampling unit 23 and a second sampling unit 24.

The first sampling unit 23 and the second sampling unit 24 are connected in series.

The first sampling unit 23 and the second sampling unit 24 may be respectively formed by resistors. The number and resistance of the resistors in the first sampling unit 23 and the second sampling unit 24 may be set based on a normal voltage range of the sampling detection point to which the sampling branch 20 is connected. For example, when the terminal voltage of the battery 40 is relatively high, if the normal voltage range of the sampling detection point includes a high voltage, a resistor with high resistance may be disposed for the first sampling unit 23, and a resistor with low resistance may be disposed for the second sampling unit 24, so that after the first sampling unit 23 and the second sampling unit 24 divide the voltage at the sampling detection point, a voltage difference between two ends of the second sampling unit 24 is kept from being excessively large and exceeding a detection range of the sampling module 10, and is also kept from being excessively small and affecting the accuracy of a sampling result.

According to some embodiments of the present disclosure, referring to FIG. 8, the sampling module 10 may include a first sampling end S1, sampling points of the sampling branch 20 may include a first sampling point, and the first sampling point is disposed in the middle of the first sampling unit 23 and the second sampling unit 24.

The first sampling point of the sampling branch 20 may be connected to the first sampling end S1 of the sampling module 10, and the sampling module 10 may obtain a voltage at the first sampling point through the first sampling end S1.

After obtaining the voltage at the first sampling point through the first sampling point, the sampling module 10 may determine the voltage difference between the two ends of the sampling branch 20 based on the equivalent resistance of the first sampling unit 23 and the second sampling unit 24. For example, when the equivalent resistance of the first sampling unit 23 is R1, the equivalent resistance of the second sampling unit 24 is R2, the voltage value at the first sampling point is Vp, and the reference voltage is Tsref, a formula for calculating the voltage difference between the two ends of the sampling branch 20 is as follows: $V 1 = \left(Vp-Vref\right) * \left(R1+R2\right) / R 2 .$

Because the two ends of the sampling branch 20 are respectively connected to the sampling detection point and the reference sampling point, the voltage difference between the two ends of the sampling branch 20 is a voltage difference between the sampling detection point and the reference sampling point.

When the reference ground is the second terminal of the battery, the sampling module 10 may determine the voltage of the sampling detection point with respect to the second terminal of the battery based on the voltage difference between the two ends of the sampling branch 20 and the reference voltage supplied by the voltage source 50. The formula is as follows: $V = V 1 + Vref .$

Vref is the reference voltage between the reference sampling point and the second terminal of the battery, and V is the voltage of the sampling detection point with respect to the second terminal of the battery.

According to some embodiments of the present disclosure, referring to FIG. 9, the sampling module 10 may include a second sampling end S2, sampling points of the sampling branch 20 may include a second sampling point, and the second sampling point is disposed at two ends of the second sampling unit 24. That is, the second sampling point includes at least two sampling points at the two ends of the second sampling unit 24.

The second sampling point of the sampling branch 20 may be connected to the second sampling end S2 of the sampling module 10, and the sampling module 10 may obtain a voltage at the second sampling point through the second sampling end S2. When two second sampling points are provided, two second sampling ends S2 of the sampling module 10 are also provided.

The sampling module 10 may directly sample the terminal voltage of the second sampling unit 24 through the second sampling end S2. After the terminal voltage of the second sampling unit 24 is determined, the voltage difference between the two ends of the sampling branch 20 may be calculated based on the equivalent resistance of the first sampling unit 23 and the second sampling unit 24. For example, when the equivalent resistance of the first sampling unit 23 is R1, the equivalent resistance of the second sampling unit 24 is R2, and the terminal voltage of the second sampling unit 24 acquired by the second sampling end S2 of the sampling module 10 is Vq, a formula for calculating the voltage difference between the two ends of the sampling branch 20 is as follows: $V 2 = Vq * \left(R1+R2\right) / R 2 .$

Because the two ends of the sampling branch 20 are respectively connected to the sampling detection point and the reference sampling point, the voltage difference between the two ends of the sampling branch 20 is a voltage difference between the sampling detection point and the reference sampling point.

When the reference ground is the second terminal of the battery, the sampling module 10 may determine the voltage of the sampling detection point with respect to the second terminal of the battery based on the voltage difference between the two ends of the sampling branch 20 and the reference voltage supplied by the voltage source 50. The formula is as follows: $V = V 2 + Vref .$

Vref is the reference voltage between the reference sampling point and the second terminal of the battery, and V is the voltage of the sampling detection point with respect to the second terminal of the battery.

According to some embodiments of the present disclosure, the second sampling end S2 of the sampling module 10 may be a differential sampling end, that is, the second sampling end S2 may perform differential sampling on the two ends of the second sampling unit 24, to obtain a voltage difference between the two ends of the second sampling unit 24.

The sampling module 10 may be a sampling chip, and a sampling manner of the sampling chip may be differential sampling, or may be conventional sampling.

When the sampling manner of the sampling chip is differential sampling, the sampling end corresponding to the sampling branch 20 is the second sampling end S2, and the second sampling end S2 includes a positive sampling end and a negative sampling end. The positive sampling end should be connected to one of the two ends of the second sampling unit 24 in the sampling branch 20 that has a higher voltage, and the negative sampling end should be connected to one of the two ends of the second sampling unit 24 that has a lower voltage.

When the sampling branch 20 is the first sampling branch 21, an intermediate voltage of the first sampling unit 23 and the second sampling unit 24 is greater than the voltage at the reference sampling point. In this case, the positive sampling end in the second sampling end S2 should be connected to the middle of the first sampling unit 23 and the second sampling unit 24, and the negative sampling end is connected to the other end of the second sampling unit 24.

In contrast, when the sampling branch 20 is the second sampling branch 22, the intermediate voltage of the first sampling unit 23 and the second sampling unit 24 is less than the voltage at the reference sampling point. In this case, the negative sampling end in the second sampling end S2 should be connected to the middle of the first sampling unit 23 and the second sampling unit 24, and the positive sampling end is connected to the other end of the second sampling unit 24.

It should be noted that the sampling chip may include a plurality of second sampling ends S2. When the plurality of sampling detection points need to be detected in the sampling circuit, each second sampling end S2 may be connected to the corresponding sampling branch 20.

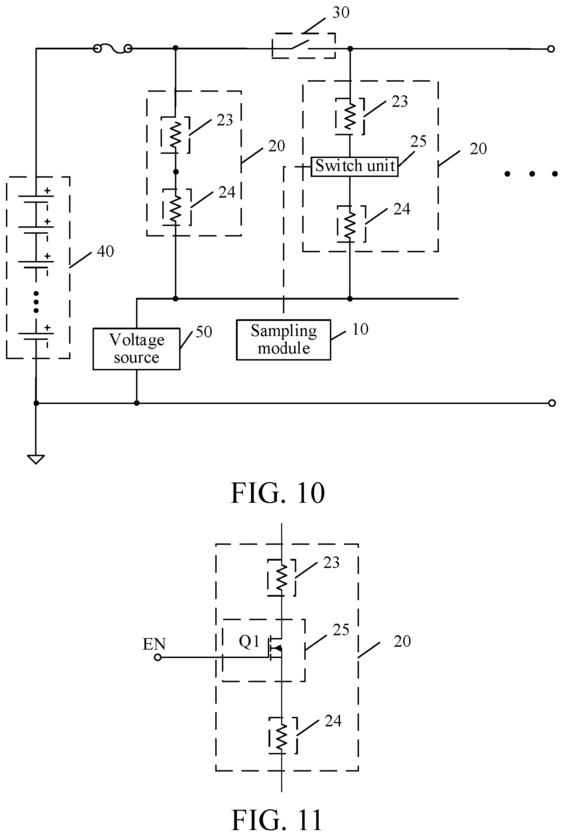

According to some embodiments of the present disclosure, referring to FIG. 10, the sampling branch 20 may further include a switch unit 25, and the switch unit 25 can enable the sampling branch 20 to be turned on.

The switch unit 25 may be connected between the first sampling unit 23 and the second sampling unit 24. The switch unit 25 may be switched between an on state and an off state, to enable the first sampling unit 23 and the second sampling unit 24 to be connected to and disconnected from each other.

As shown in FIG. 10, because a voltage between the positive electrode and the negative electrode of the battery 40 needs to be detected in real time, the switch unit 25 may not be disposed for the sampling branch 20 corresponding to the sampling detection point that is directly connected to the first terminal of the battery 40. That is, the first sampling unit 23 and the second sampling unit 24 remain connected.

For the sampling detection point connected to the first terminal or the negative electrode of the battery 40 by the switch assembly 30, when the switch assembly 30 is not turned on, an off state of the switch assembly 30 does not need to be detected. The off state of the switch assembly 30 needs to be detected only after the switch assembly 30 is turned on and performs a corresponding function and when the switch assembly 30 is controlled to be turned off. Therefore, through the arrangement of the switch unit 25 in the sampling branch 20, when the sampling detection point corresponding to the sampling branch 20 requires voltage sampling, that is, the switch assembly 30 is turned off, the switch unit 25 can be controlled to connect the first sampling unit 23 to the second sampling unit 24 to implement voltage sampling.

In another optional implementation, the switch unit 25 may alternatively be provided for the sampling branch 20 corresponding to the sampling detection point that is directly connected to the first terminal of the battery 40.

According to some embodiments of the present disclosure, referring to FIG. 10 again, the sampling module 10 may be connected to the switch unit 25, and the sampling module 10 may control the switch unit 25 to be turned on or turned off.

The sampling module may include a sampling chip, the sampling chip may further include a switch control end, and the switch control end may be connected to the switch unit 25 to control the on state of the switch unit 25. When the sampling function needs to be enabled, the sampling chip may send a turn-on signal to the switch unit 25, so that the switch unit 25 connects the first sampling unit 23 to the second sampling unit 24.

According to some embodiments of the present disclosure, the switch unit 25 may include, but is not limited to, at least one of a transistor, an optoelectronic device, and a relay. The switch unit 25 may alternatively be another switch device or switch equipment that can implement on-off control.

According to some embodiments of the present disclosure, referring to FIG. 11, the switch unit 25 may include a first MOSFET Q1.

The first MOSFET Q1 may be connected between the first sampling unit 23 and the second sampling unit 24, and a control end of the first MOSFET Q1 is connected to an enable signal end.

When the control end of the first MOSFET Q1 receives a non-enable signal, the first MOSFER is turned off. In this case, the first sampling unit 23 is not connected to the second sampling unit 24, and the sampling branch 20 does not operate.

When the control end of the first MOSFET Q1 receives an enable signal, the first MOSFER is turned on. In this case, the first sampling unit 23 is connected to the second sampling unit 24, and the sampling branch 20 can divide a voltage at the sampling detection point, so that the sampling module 10 can obtain the voltage of the sampling detection point with respect to the reference sampling point.

It may be understood that the switch unit 25 may be a MOSFET device, or may include, but is not limited to, another power switch device capable of adapting to a voltage range of a corresponding sampling detection point.

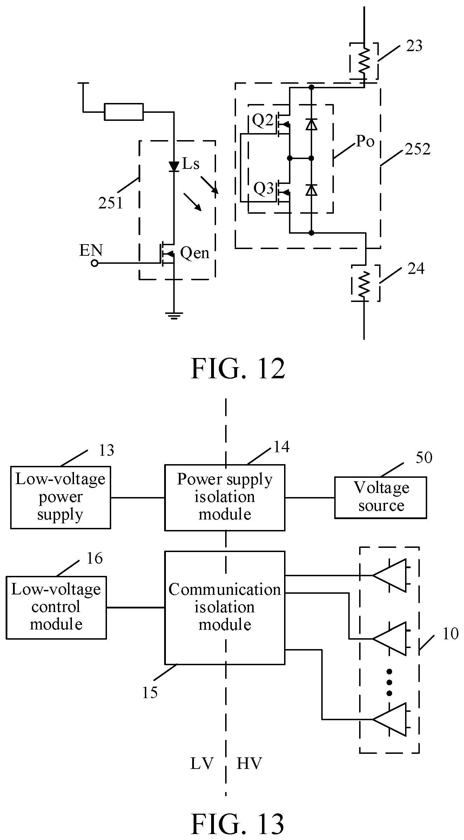

According to some embodiments of the present disclosure, referring to FIG. 12, the switch unit 25 may include a control assembly 251 and a controlled assembly 252 that are isolated from each other. The controlled assembly 252 is connected between the first sampling unit 23 and the second sampling unit 24, and the control assembly 251 may control the controlled assembly 252 to be turned on and turned off.

The control assembly 251 may control, based on a corresponding control signal, the controlled assembly 252 isolated from the control assembly 251 to be turned on or turned off. When the controlled assembly 252 is turned on, the first sampling unit 23 can be connected to the second sampling unit 24. When the controlled assembly 252 is turned off, the first sampling unit 23 can be disconnected from the second sampling unit 24.

Different from the foregoing embodiment in which the first MSFET Q1 is used as the switch unit 25, in this embodiment, the control assembly 251 and the controlled assembly 252 are isolated from each other. Because the terminal voltage of the battery 40 is usually a high voltage, when a controller providing an enable signal to the switch unit 25 is a controller in a high-voltage environment, a signal end of the controller may be directly connected to the first MOSFET Q1, and an on state of the first MOSFET Q1 is controlled by using the controller, to implement switching control of the sampling branch 20.

If a controller providing a control signal to the switch unit 25 is a controller in a low-voltage environment, to prevent a high voltage through which the sampling branch 20 flows from affecting the controller in the low-voltage environment, the switch unit 25 may be disposed as a control part and a controlled part that are isolated from each other. The control part is connected to the controller in the low-voltage environment, and the controlled part is connected to a sampling branch 20 in the high-voltage environment. The controller is isolated from the sampling branch 20, so that isolation and protection of the controller can be implemented, thereby improving the reliability of voltage sampling in the high-voltage environment.

According to some embodiments of the present disclosure, still referring to FIG. 12, the control assembly 251 may include an enable switch Qen and a light-emitting source Ls that are connected in series, and the controlled assembly 252 may include a light receiver Po.

A control end of the enable switch Qen is connected to the enable signal end, and the enable switch Qen can connect, when being turned on, the light-emitting source Ls to a power supply signal, to drive the light-emitting source Ls to emit light.

The light receiver Po may be connected between the first sampling unit 23 and the second sampling unit 24, and is turned on when the light-emitting source Ls emits light.

In this embodiment, the controller in the low-voltage environment may send an enable signal to the enable switch Qen. The enable switch Qen may drive, when being turned on, the light-emitting source Ls to emit light. The light receiver Po is turned on when the light-emitting source Ls emits light, and the first sampling unit 23 is connected to the second sampling unit 24, so that the sampling module 10 can perform voltage sampling on the sampling detection point corresponding to the sampling branch 20.

According to some embodiments of the present disclosure, as shown in FIG. 12, the light receiver Po may include a second MOSFET Q2 and a third MOSFET Q3.

A first end of the second MOSFET Q2 is connected to the first sampling unit 23, a second end of the second MOSFET Q2 is connected to a first end of the third MOSFET Q3, and a second end of the third MOSFET Q3 is connected to the second sampling unit 24. A positive electrode of a body diode of the second MOSFET Q2 is connected to a positive electrode of a body diode of the third MOSFET Q3.

To avoid that a current can still unidirectionally flow through a body diode of a single MOSFET when the MOSFET is turned off, the second MOSFET Q2 and the third MOSFET Q3 may be disposed in series. When the second MOSFET Q2 and the third MOSFET Q3 are both turned off, the body diode of the second MOSFET Q2 can limit the flow of the current from the sampling detection point to the reference sampling point, and the body diode of the third MOSFET Q3 can limit the flow of the current from the reference sampling point to the sampling detection point. Bi-directional current limitation between the sampling detection point and the reference sampling point can be implemented by using the second MOSFET Q2 and the third MOSFET Q3.

Based on the same inventive concept, the present disclosure further provides a battery management system. The battery management system includes the sampling circuit in any one of the foregoing embodiments. It may be understood that the battery management system has beneficial effects of the sampling circuit provided in the embodiments of the present disclosure. For details, refer to specific descriptions of the sampling circuit in the foregoing embodiments. Details are not described herein again in this embodiment.

According to some embodiments of the present disclosure, the battery management system may include:
a plurality of switch assemblies, each switch assembly being connected between a battery and a corresponding load, and configured to connect the battery to the corresponding load or disconnect the battery from the corresponding load;
a sampling circuit, the sampling circuit including sampling branches in a one-to-one correspondence with the plurality of switch assemblies, and each sampling branch being configured to acquire a voltage at a sampling detection point, where a first end of each sampling branch is connected to a corresponding switch assembly, and a connection point is the sampling detection point; a second end of each sampling branch is connected to a voltage source, and a connection point is a reference sampling point; and a third end of each sampling branch is connected to a sampling module;
the voltage source, configured to supply a reference voltage to the reference sampling point; and
the sampling module, connected to a high-voltage ground, and configured to obtain a voltage of each sampling detection point with respect to the reference sampling point.

In the embodiments of the present disclosure, through the arrangement of the voltage source, the sampling module, and the sampling branches, the reference voltage may be supplied to the reference sampling point through the voltage source, so that a voltage of the reference sampling point with respect to a reference ground is the reference voltage. The sampling module may determine a sampling result based on a sampled voltage of the sampling detection point with respect to the reference sampling point and the reference voltage between the reference sampling point and the reference ground. In this way, the sampling branches share the same reference sampling point, and sampling is directly performed with respect to the reference voltage, thereby simplifying the circuit design and reducing circuit costs. In addition, the sampling module is connected to the high-voltage ground, so that the issue of insulation withstand voltage no longer needs to be considered for the sampling module, and the voltage withstand rating selection for a switch device is relatively flexible. In addition, the sampling circuit belongs to a high-voltage region, and is no longer connected to a low voltage. In addition, interference immunity can be improved, and an isolation device does not need to be disposed, thereby reducing costs.

According to some embodiments of the present disclosure, the battery management system further includes: a voltage conversion module, the voltage conversion module being connected to the voltage source, and configured to convert the reference voltage of the voltage source to provide corresponding sampling ranges for sampling detection points with different reference voltage requirements, respectively.

In this embodiment of the present disclosure, the reference voltage supplied by the voltage source is adjustable, so that the sampling detection points can be sampled with respect to different reference voltages, thereby meeting different sampling requirements.

According to some embodiments of the present disclosure, the plurality of switch assemblies include at least one first switch assembly and/or at least one second switch assembly, and correspondingly, the sampling branches include: a first sampling branch disposed corresponding to the first switch assembly, a sampling detection point corresponding to the first sampling branch being connected to a first terminal of the battery, or a sampling detection point corresponding to the first sampling branch being connected to the first terminal of the battery by the first switch assembly; and a second sampling branch disposed corresponding to the second switch assembly, a sampling detection point corresponding to the second sampling branch being connected to a second terminal of the battery by the second switch assembly.

In this embodiment of the present disclosure, the first sampling branch and the second sampling branch may perform voltage sampling on the sampling detection point connected to the first terminal of the battery and the sampling detection point connected to the second terminal of the battery, respectively, so that the first sampling branch and/or the second sampling branch share the same reference sampling point, and sampling is directly performed with respect to the reference voltage, thereby simplifying the circuit design and reducing circuit costs.

According to some embodiments of the present disclosure, the plurality of switch assemblies further include switch assemblies connected in parallel, and the sampling branches further include: a third sampling branch, connected to one end of the switch assemblies connected in parallel; and a fourth sampling branch, connected to the other end of the switch assemblies connected in parallel.

In this embodiment of the present disclosure, the switch assemblies connected in parallel may mean that at least two switch assemblies are connected in parallel. FIG. 6 is used as an example. The at least two switch assemblies connected in parallel may include a switch assembly in which the main positive switch K2 is located and a switch assembly in which the pre-charging switch K3 is located. One end of the two switch assemblies is connected to a third sampling branch 21a, and the other end of the two switch assemblies is connected to a fourth sampling branch 21b, thereby implementing multiplexing of the sampling branches.

It should be noted that besides a corresponding switch, the switch assembly may further include another device. This is not limited herein. For example, for the switch assembly in which the pre-charging switch K3 is located, the switch assembly may be considered as including the pre-charging switch K3 and a precharge resistor connected in series.

It should be further noted that in this embodiment of the present disclosure, a sampling detection point corresponding to the third sampling branch 21a is directly connected to the first terminal of the battery 40, and a sampling detection point corresponding to the fourth sampling branch 21b is connected to the first terminal of the battery 40 by the switch assemblies connected in parallel (including, for example, the switch assembly in which the main positive switch K2 is located and the switch assembly in which the pre-charging switch K3 is located), respectively. After a voltage difference between the two sampling detection points corresponding to the third sampling branch 21a and the fourth sampling branch 21b is calculated, the voltage difference may be compared with a preset voltage threshold, to determine whether a fault such as relay sticking exists on the main positive switch K2 or the pre-charging switch K3.

In other words, when at least two switch assemblies are connected in parallel, the at least two switch assemblies can multiplex the same sampling branch (including the third sampling branch and the fourth sampling branch), so that through multiplexing of the sampling branch, the circuit design can be simplified, and circuit costs can be reduced.

According to some embodiments of the present disclosure, the sampling branch includes: a first sampling unit and a second sampling unit, the first sampling unit and the second sampling unit being connected in series. In this way, the first sampling unit and the second sampling unit are disposed to divide the voltage at the sampling detection point, so that the divided voltage falls within the sampling range.

According to some embodiments of the present disclosure, sampling points in the sampling branch include a first sampling point, and the sampling module includes a first sampling end; the first sampling point is disposed between the first sampling unit and the second sampling unit; and the first sampling point is connected to the first sampling end of the sampling module. In this way, through the arrangement that the first sampling end of the sampling module is connected to the first sampling point of the sampling branch, voltage sampling of the sampling branch with respect to the reference voltage is implemented.

According to some embodiments of the present disclosure, sampling points in the sampling branch include a second sampling point, and the sampling module includes a second sampling end; the second sampling point of the sampling branch is disposed at two ends of the second sampling unit; and the second sampling point is connected to the second sampling end of the sampling module.

In this embodiment of the present disclosure, through the arrangement that the second sampling end of the sampling module is connected to the second sampling point of the sampling branch, so that the terminal voltage of the second sampling unit can be directly sampled, and the voltage of the sampling detection point with respect to the reference sampling point can be determined with reference to a voltage division ratio of the first sampling unit to the second sampling unit.

According to some embodiments of the present disclosure, the second sampling end of the sampling module is a differential sampling end. In this way, differential sampling is performed on the terminal voltage of the second sampling unit in a differential sampling manner, so that the terminal voltage of the second sampling unit can be directly obtained.

According to some embodiments of the present disclosure, the sampling branch further includes: a switch unit, the switch unit being configured to connect the sampling branch. In this way, through the arrangement of the switch unit, the application of the sampling branch can be flexibly controlled.

According to some embodiments of the present disclosure, the sampling module is connected to the switch unit, and the sampling module is configured to control the switch unit to be turned on or turned off. In this way, the switch unit is controlled through the sampling module to be turned on, so that the switch unit can be controlled to be turned on when sampling needs to be performed, and the switch unit can be turned off when sampling is not required, thereby improving the flexibility of sampling control.

According to some embodiments of the present disclosure, the switch unit includes at least one of a transistor, an optoelectronic device, and a relay. In this way, through the arrangement of the switch device, the on-off control of the sampling branch can be implemented.

According to some embodiments of the present disclosure, the voltage source is connected to the second terminal of the battery, and the reference voltage is a voltage difference between the reference sampling point and the second terminal of the battery. In this way, the second terminal of the battery is used as the reference ground, and the sampling module may determine a sampling result based on a sampled voltage of the sampling point in the sampling branch with respect to the reference sampling point and the reference voltage between the reference sampling point and the reference ground.

According to some embodiments of the present disclosure, the switch assembly includes any one of a main positive switch, a main negative switch, a pre-charging switch, a main positive direct current charging switch, a main positive alternating current charging switch, a main negative charging switch, a heating switch, and a load switch. In this way, through voltage sampling at the sampling detection points at two ends of each switch assembly, whether a fault such as sticking occurs at the switch assembly may be determined based on a voltage difference between the two ends of the switch assembly.

According to some embodiments of the present disclosure, referring to FIG. 13, the battery management system may further include a low-voltage power supply 13, a power supply isolation module 14, a communication isolation module 15, and a low-voltage control module 16.

The low-voltage power supply 13 may supply a reference voltage to the voltage source 50. The power supply isolation module 14 may be connected between the low-voltage power supply 13 and the voltage source 50, to isolate the low-voltage power supply 13 from the voltage source 50. Because the voltage source 50 operates in a high-voltage environment and the low-voltage power supply 13 operates in a low-voltage environment, the power supply isolation module 14 can isolate the low-voltage environment from the high-voltage environment.

A first end of the communication isolation module 15 is connected to a sampling output end of the sampling module 10, and a second end of the communication isolation module 15 is connected to a voltage input end of the low-voltage control module 16.

The communication isolation module 15 may be connected between the voltage input end of the low-voltage control module 16 and the sampling output end of the sampling module 10, to convert a sampled signal output by the sampling module 10 from an analog signal into a digital signal, and send the digital signal to the low-voltage control module 16.

The low-voltage control module 16 may determine a voltage of a corresponding sampling detection point with respect to the reference sampling point based on the digital signal, and calculate a voltage of the sampling detection point with respect to the reference ground based on a sum of the voltage and the reference voltage. When the reference ground is disposed as the second terminal of the battery, the voltage of the sampling detection point with respect to the second terminal of the battery can be determined.

Based on the same inventive concept, the present disclosure further provides a battery pack. The battery pack includes a battery and the battery management system in any one of the foregoing embodiments. It may be understood that the battery pack has the beneficial effects of the battery management system provided in this embodiment of the present disclosure.

Based on the same inventive concept, the present disclosure further provides a power consuming apparatus. The power consuming apparatus includes the battery pack in any one of the foregoing embodiments. It may be understood that the power consuming apparatus has beneficial effects of the battery pack provided in the embodiments of the present disclosure. For details, refer to specific descriptions of the battery pack in the foregoing embodiments. Details are not described herein again in this embodiment.

It should be noted that the embodiments in the present disclosure and the features in the embodiments may be combined with each other without causing any conflict.

The functional blocks shown in the foregoing structural block diagrams may be implemented as hardware, software, firmware, or a combination thereof. When implemented in a hardware manner, the functional blocks may be, for example, an electronic circuit, an application-specific integrated circuit (ASIC), proper firmware, a plug-in, a functional card, or the like. When implemented in a software manner, an element of the present disclosure is a program or a code segment used for executing a required task. The program or code segment may be stored in a machine-readable medium, or transmitted on a transmission medium or a communication link by using a first data signal carried in a carrier. The "machine-readable medium" may include any medium that can store or transmit information. Examples of the machine-readable medium include an electronic circuit, a semiconductor memory device, a ROM, a flash memory, an erasable ROM (EROM), a floppy disk, a CD-ROM, an optical disc, a hard disk, a fiber optic medium, a radio frequency (RF) link, and the like. The code segment may be downloaded by using a computer network, for example, the Internet or an intranet.

It should be noted that, the terms "include", "comprise" or any variants thereof herein are intended to cover non-exclusive inclusion, such that a process, a method, an article or a device comprising a series of elements comprise not only those elements, but also other elements not listed explicitly, or elements inherent to this process, method, article or device.

Although the principle and implementations of the present disclosure are described by using specific examples in this specification, descriptions of the examples are merely intended to help understand the methods and core idea of the present disclosure. The foregoing descriptions are merely preferred implementations of the present disclosure. It should be noted that due to the inherent limitations of textual expression, while objectively an infinite variety of concrete structures exist, those of ordinary skill in the art may make several improvements, modifications, or variations without departing from the principles of the present disclosure, and may also combine the above technical features in an appropriate manner. All such improvements, modifications, variations, combinations, or the direct application of the concepts and technical solutions of the present disclosure to other scenarios without improvements shall be deemed as falling within the scope of protection of the present disclosure.

### Industrial Applicability

In the embodiments of the present disclosure, through the arrangement of the voltage source, the sampling module, and the sampling branches, the reference voltage may be supplied to the reference sampling point through the voltage source, so that a voltage of the reference sampling point with respect to a reference ground is the reference voltage. The sampling module may determine a sampling result based on a sampled voltage of the sampling detection point with respect to the reference sampling point and the reference voltage between the reference sampling point and the reference ground. In this way, the sampling branches share the same reference sampling point, and sampling is directly performed with respect to the reference voltage, thereby simplifying the circuit design and reducing circuit costs. In addition, the sampling module is connected to the high-voltage ground, so that the issue of insulation withstand voltage no longer needs to be considered for the sampling module, and the voltage withstand rating selection for a switch device is relatively flexible. In addition, the sampling circuit belongs to a high-voltage region, and is no longer connected to a low voltage. In addition, interference immunity can be improved, and an isolation device does not need to be disposed, thereby reducing costs.

## Claims

1. A battery management system, comprising:
a plurality of switch assemblies, each switch assembly being connected between a battery and a corresponding load, and configured to connect the battery to the corresponding load or disconnect the battery from the corresponding load;
a sampling circuit, the sampling circuit comprising sampling branches in a one-to-one correspondence with the plurality of switch assemblies, and each sampling branch being configured to acquire a voltage at a sampling detection point, wherein a first end of each sampling branch is connected to a corresponding switch assembly, and a connection point is the sampling detection point; a second end of each sampling branch is connected to a voltage source, and a connection point is a reference sampling point; and a third end of each sampling branch is connected to a sampling module;
the voltage source, configured to supply a reference voltage to the reference sampling point; and
the sampling module, connected to a high-voltage ground, and configured to obtain a voltage of each sampling detection point with respect to the reference sampling point.

2. The battery management system according to claim 1, wherein the battery management system further comprises:
a voltage conversion module, the voltage conversion module being connected to the voltage source, and configured to convert the reference voltage of the voltage source to provide corresponding sampling ranges for sampling detection points with different reference voltage requirements, respectively.

3. The battery management system according to claim 1 or 2, wherein the plurality of switch assemblies comprise at least one first switch assembly and/or at least one second switch assembly, and the sampling branches comprise:
a first sampling branch disposed corresponding to the first switch assembly, a sampling detection point corresponding to the first sampling branch being connected to a first terminal of the battery, or a sampling detection point corresponding to the first sampling branch being connected to the first terminal of the battery by the first switch assembly; and
a second sampling branch disposed corresponding to the second switch assembly, a sampling detection point corresponding to the second sampling branch being connected to a second terminal of the battery by the second switch assembly.

4. The battery management system according to claim 1 or 2, wherein the plurality of switch assemblies further comprise switch assemblies connected in parallel, and the sampling branches further comprise:
a third sampling branch, connected to one end of the switch assemblies connected in parallel; and
a fourth sampling branch, connected to the other end of the switch assemblies connected in parallel.

5. The battery management system according to any one of claims 1 to 4, wherein the sampling branch comprises:
a first sampling unit and a second sampling unit, the first sampling unit and the second sampling unit being connected in series.

6. The battery management system according to claim 5, wherein sampling points in the sampling branch comprise a first sampling point, and the sampling module comprises a first sampling end;
the first sampling point is disposed between the first sampling unit and the second sampling unit; and
the first sampling point is connected to the first sampling end of the sampling module.

7. The battery management system according to claim 5, wherein sampling points in the sampling branch comprise a second sampling point, and the sampling module comprises a second sampling end;
the second sampling point of the sampling branch is disposed at two ends of the second sampling unit; and
the second sampling point is connected to the second sampling end of the sampling module.

8. The battery management system according to claim 7, wherein the second sampling end of the sampling module is a differential sampling end.

9. The battery management system according to any one of claims 5 to 8, wherein the sampling branch further comprises:
a switch unit, the switch unit being configured to connect the sampling branch.

10. The battery management system according to claim 9, wherein the sampling module is connected to the switch unit, and the sampling module is configured to control the switch unit to be turned on or turned off.

11. The battery management system according to claim 9, wherein the switch unit comprises at least one of a transistor, an optoelectronic device, and a relay.

12. The battery management system according to any one of claims 1 to 11, wherein the voltage source is connected to the second terminal of the battery, and the reference voltage is a voltage difference between the reference sampling point and the second terminal of the battery.

13. The battery management system according to any one of claims 1 to 12, wherein the switch assembly comprises any one of a main positive switch, a main negative switch, a pre-charging switch, a main positive direct current charging switch, a main positive alternating current charging switch, a main negative charging switch, a heating switch, and a load switch.

14. The battery management system according to any one of claims 1 to 13, wherein the battery management system further comprises:
a low-voltage power supply;
a power supply isolation module, connected between the low-voltage power supply and the voltage source;
a low-voltage control module; and
a communication isolation module, connected between a voltage input end of the low-voltage control module and a sampling output end of the sampling module.

15. A battery pack, comprising a battery and the battery management system according to any one of claims 1 to 14.

16. A power consuming apparatus, comprising the battery pack according to claim 15.
